# EUROPEAN PATENT SPECIFICATION

(11) **EP 0 514 980 B1**
(45) Date of publication and mention of the grant of the patent: **25.09.1996**
(21) Application number: 92201391.7
(22) Date of filing: 15.05.1992
(51) Int. Cl.: H03K 17/04

(54) **Driving circuit of a power transistor with a base current being a given function of that of the collector**
Ansteuerschaltung für einen Leistungstransistor mit dem Basisstrom als gegebene Funktion des Kollektorstromes
Circuit de commande pour transistor de puissance dont le courant de base est une fonction donnée du courant de collecteur

(30) Priority: 21.05.1991 IT MI911390
(43) Date of publication of application: 25.11.1992
(73) Proprietor: CONSORZIO PER LA RICERCA SULLA MICROELETTRONICA NEL MEZZOGIORNO, I-95121 Catania (IT)
(72) Inventor: Sueri, Stefano, I-95129 Catania (IT); Palara, Sergio, I-95021 Acicastello (Catania) (IT)
(74) Representative: Mittler, Enrico

(56) References cited:
- US-A- 4 910 480
- US-A- 4 961 006
- US-A- 4 990 864

## Description

The present invention relates to a driving circuit of a power transistor with a base current being a given function of that of the collector.

Let us consider a circuit in which there is a power NPN transistor (or darlington) with an inductor as a load on the collector of the power transistor.

A driving circuit supplies at input (base) the power transistor so that, for a voltage value of zero at the input of the driving device, the collector current of the power transistor is zero. From the moment when the voltage across the input of the driving device goes high, the current on the collector of the power transistor begins to rise in a linear form.

Normally the current necessary to drive the power transistor at base is equal to a maximum value of the base current right from the moment at which the voltage across the input of the driving device goes high. Such maximum value of the base current is that suitable for driving the power transistor to a maximum value of the collector current.

Such drive, however, determines a waste of base current, as well as of power dissipated, since it is not necessary to have a maximum value of the base current as soon as the voltage across the input of the driving device goes high.

As described in the Italian patent application No. 19502 A/89 filed on 21 February 1989 in the name of SGS-THOMSON MICROELECTRONICS s.r.l., a method alternative to the one decribed above provides for the drive of the power transistor to be accomplished by using a base current of the power transistor proportional to the collector current of the same.

In this case a minimum value of the gain of the power transistor is fixed and it is imposed that, with the exclusion of the initial instant, for each value of the collector current on the power transistor the base current of the power transistor is equal to the ratio between its collector current and its minimum gain presumed constant.

This latter type of drive is advantageous with respect to the previous one, but it is not optimized because the gain of the power transistor is not constant as the collector current varies and as the junction temperature varies.

In addition, the circuit that accomplishes it is fairly complex since it must comprise:
- a meter of the base current of the power transistor,
- a meter of the emitter current of the power transistor,
- a current amplifier to compare at input the output signals of the base and emitter current meters and to operate at output on a control circuit of the power transistor.

The control circuit thus operates on the base current of the power transistor, so as to make it proportional to the collector current.

Since this is a fed-back circuit, the driving circuit thus accomplished has the disadvantage that it must be compensated in frequency and can give rise to instability.

In U.S. 4,961,006 an inductively loaded transistor circuit with automatic base current control is disclosed, substantially as described in the preamble of claim 1.

The object of the present invention is to accomplish a driving circuit of a power transistor with a base current being a given function of that of the collector, wherein the regulation of the base current takes into account the curve of the gain of the power transistor as the collector current and the junction temperature vary.

Another object is that of accomplishing a driving circuit of the type mentioned above, that is also constructively simple and does not require frequency compensations in order to avoid instability.

According to the invention such object is attained with a driving circuit for a power transistor, which further includes the features of the characterizing clause of claim 1.

By means of this arrangement it is possible to supply to the power transistor a driving base current that is proportional to a current that is in turn a function of the voltage across the detection resistance and thus dependent on the collector current and on the gain of the power transistor.

In this way, through the circuit according to the present invention there is determined a base current that varies as a function of the collector current itself, but takes into account the gain of the power transistor both as a function of the collector current and of the junction temperature.

The use of the above circuit accomplishment also allows a circuit to be obtained that is simple to manufacture and at the same time stable, since, not being fed back, it needs no frequency compensation.

The features of the present invention shall be made more evident by the embodiments illustrated as a non-limiting example in the enclosed drawings, wherein:
Fig. 1 illustrates a first circuit accomplishment of the circuit according to the present invention;
Fig. 2 illustrates a second circuit accomplishment of the circuit according to the present invention;
Fig.s 3, 4 illustrate the curve of the theoretical gain of the power transistor at different temperatures and as a function of the collector current and the real one with the circuit according to the present invention, respectively;
Fig.s 5, 6 illustrate the curves against time of the base current and of the collector current, respectively, of the power transistor at the different temperatures, obtained by means of the circuit according to the present invention.

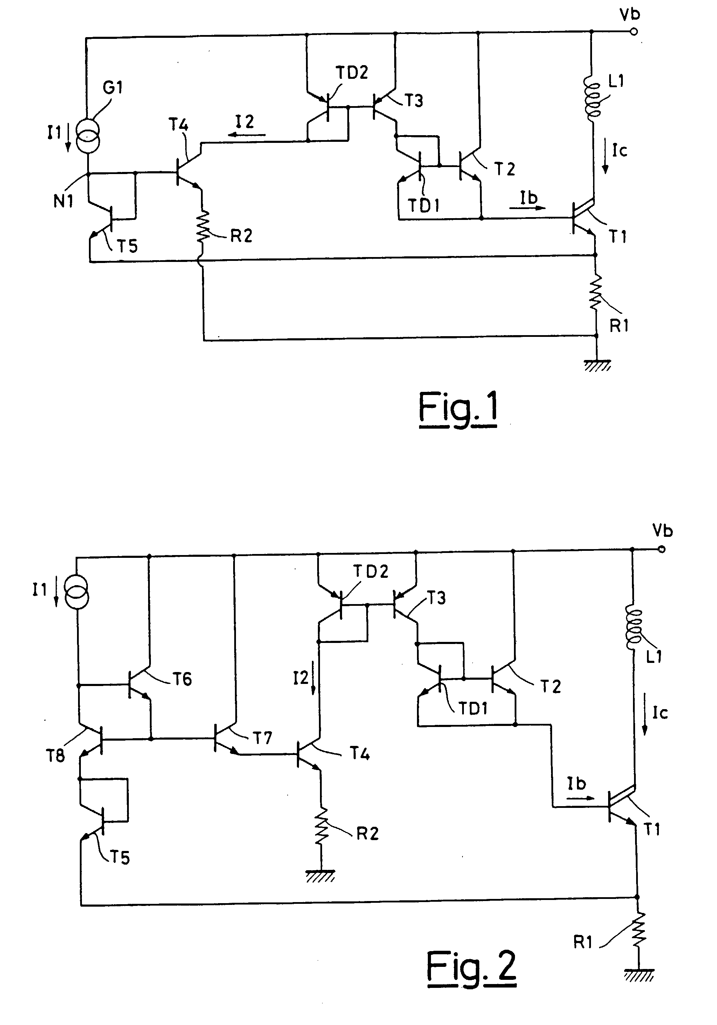

With reference to Fig. 1, a bipolar power transistor T1 of the type NPN, represented as an example in a darlington configuration, is connected through an inductive load L1 across its collector to a supply voltage Vb. The emitter of the power transistor T1 is connected to ground through a detection resistance R1. The base of the power transistor T1 is connected to the emitter of a bipolar transistor T2 of the type NPN arranged in a current-mirror configuration with a diode transistor TD1. The collector of the transistor T2 is connected to the power supply Vb, while the base is connected, as well as to the collector and to the base of the diode transistor TD1, to the collector of a bipolar transistor T3 of the type NPN arranged in a current-mirror configuration with a diode transistor TD2. The emitter of the transistor T3 is connected to the power supply Vb and to the emitter of the diode transistor TD2, while the base of the transistor T3 is connected to the collector and to the base of the same transistor TD2. The base of the transistor T3 is connected to the collector of a bipolar transistor T4 of the type NPN. The emitter of the transistor T4 is connected to ground through a resistance R2. The base of the transistor T4 is connected to the base of an NPN transistor T5 and to a circuit node N1 to which the collector of the transistor T5 is connected. The emitter of the transistor T5 is connected to the emitter of the transistor T1. To the circuit node N1 there is connected a current generator G1, which at the other end is connected to the supply voltage Vb.

The current-mirror configuration of the transistor T3 with the diode transistor TD2 and of the transistor T2 with the diode transistor TD1 is used to provide a base current$\text{Ib = I2(A3/AD2*A2/AD1)}$ A3, AD2, A2, AD1 being the emitter areas of T3, TD2, T2 and TD1.

If (A3/AD2*A2/AD1) = N, thus being N the multiplication factor of the current mirror of the abovementioned transistors, then Ib = NI2, where I2 is the collector current of the transistor T4.

The factor N, as well as the power transistor (or darlington) T1 are accomplished according to the known art. Components that are also accomplished according to the known art, but which are characteristic for the operation of the circuit according to the invention, are:
- the current generator G1,
- the transistor T5,
- the transistor T4 with its emitter resistance R2,
- the detection resistance R1.

In sum, if the curve of the collector current Ic of the power transistor T1 is known, the invention consists in determining a current I2 that varies as a function of Ic, taking into account the curve of the gain of the power transistor T1 in relation both to the collector current Ic and to the junction temperature.

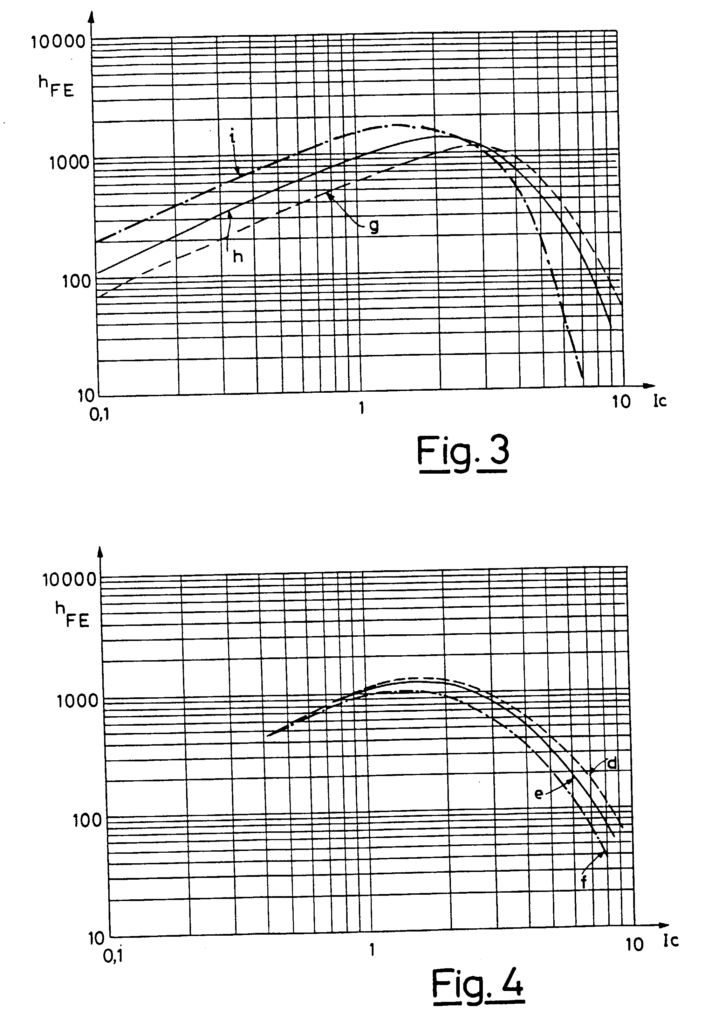

The variation of the gain h_{FE} of the power transistor as a function of the collector current Ic and to the junction temperature is illustrated by the curves of Fig. 3 The latter illustrate the variations at -40°C, curve g, 25°C, curve h, 150°C, curve i, respectively.

Since Ib = NI2, the base current of the power transistor T1 shall follow the same curve as I2.

Applying Kirschhoff's Law to the mesh consisting of the resistances R1, R2 and of the transistors T4, T5, it follows that:${\text{V}}_{\text{BE}} {\text{(T5) + R1*Ic = V}}_{\text{BE}} \text{(T4) + R2*I2}$ and since also${\text{V}}_{\text{BE}} {\text{= kT/q*ln(Ic/A}}_{\text{E}} {\text{J}}_{\text{s}} \text{)}$ where:
- K =: Boltzmann's constant
- T =: temperature of the junction in degrees Kelvin
- A_{E} =: area of the emitter
- J_{S} =: density of the inverted saturation current of a bipolar transistor
and also the collector current of the transistor T5 is equal to the current I1 generated by the generator G1,
with simple substitutions the following is obtained:$\text{Ic = (R2*I2/R1) + (kT/qR1)lnI2/I1}$

This expression gives the connection between Ic and I2: in particular for each value of Ic there is obtained a corresponding value of I2 which takes into account the trend of the gain h_{FE} of the power transistor T1.

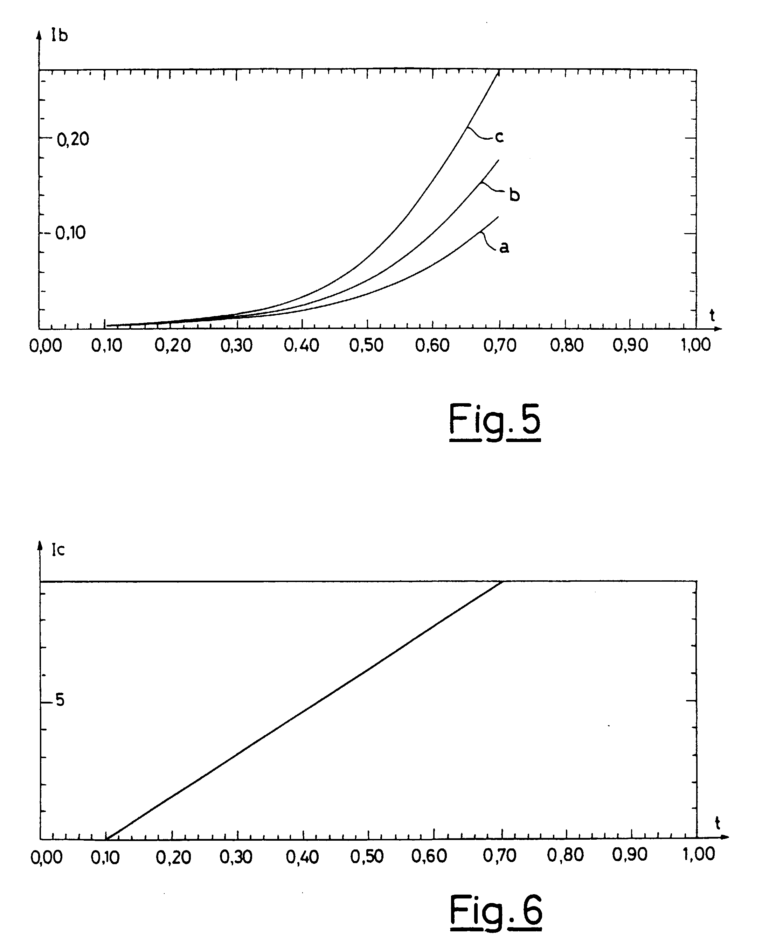

As far as its operation is concerned from a qualitative point of view, consider the instant at which Ic = 0 and let us assume that Ic has the linearly rising curve illustrated in Fig. 6, that is, following the curve of the charge current of an inductor.

Let us assume for simplicity that R2 is equal to zero; in this case we have:$\text{I2 = I1*e(R1Icq/kT)}$

This means that I2 has an exponential trend with a steeper or flatter gradient according to the value of R1.

Thus, when Ic = 0, I2 = I1, so that, taking into account that Ib = NI2, the base current of the power transistor is given by Ib = NI1.

Such value of the current is necessary to activate the power transistor T1 at the initial instant, taking into account that, should this be constituted by a darlington, the resistances present between the base and the emitter of the same convey a certain quantity of current to ground.

When the collector current Ic starts to rise, across the resistance R1 there appears a voltage that also rises linearly and as a consequence the potential of the point N1 of Fig. 1 also rises. Since it has been assumed that R2 = 0, such a voltage increase ends up by being used entirely as an increase in the base-emitter voltage of the transistor T4 with the consequent increase of the current 12 according to the expression (4).

In the case wherein the resistance R2 is greater than zero, part of the voltage R1*Ic falls across the resistance R2 and the gradient of the curve of I2 falls as R2 increases.

In the embodiment the circuit of Fig. 1 lends itself well to being integrated monolithically by using:
a) for the detection resistance R1 an aluminium metal track, whose resistivity varies as a function of the temperature of + 4500 ppm/°C;
b) for the resistance R2 a diffuse resistance according to the known art, whose resistivity varies as a function of the temperature of + 2500 ppm/°C.

With these accomplishment premises, the expression (4) gives a curve of I2, and thus of Ib = NI2, that follows the variations in gain of the power transistor as a function of the temperature especially for high values of the collector current, values for which the circuit shall mainly be used.

In fact, simulating the circuit of Fig. 1 on a computer, at the temperatures of -40°C, +25°C, +150°C, there are obtained for the current Ib the curves a, b, c of Fig. 5 which illustrate the trend of Ib at the three said temperatures as a function of Ic, whose curve is illustrated in Fig. 6 and assumed to be linearly increasing in time, since it represents the charge current of the inductor L1.

The consequent curves of the gain of the power transistor T1 as a function of Ic and of the junction temperature are given in Fig. 4, which takes the simulation of Fig.s 5 and 6 into account.

Comparing the real curve of the gain of a power transistor T1 as a function of the collector current and to the junction temperature, given in Fig. 3, with that obtained with the simulations, given in Fig. 4, it is seen that there is a satisfactory agreement mainly at high operating currents of the power transistor T1, thus attaining the object of the present invention.

In the case wherein the power device has a high gain, on the basis of the equation (4) it is necessary that I1 have a very low value, of the order of tens of microamperes.

But in this case, still with reference to Fig. 1, the contribution of the base current of T4 that is taken away from I1 can become substantial, so that in the diode-connected transistor T5 it is no longer the current I2 that flows through it but, rather, the current I1 - Ib(T4), where Ib(T4) is the base current of the transistor T4.

When the current I1 becomes of the order of tens of microamperes, almost the entire I1 becomes the base current of T4 and almost none flows through T5, thus appreciably altering the base-emitter voltage of T5 and as a consequence the correct operation of the entire circuit.

In the case wherein I1 is low, the preferred solution is that illustrated in Fig. 2.

The circuit of Fig. 2 differs from that of Fig. 1 due to the presence of further transistors T6, T7, T8 suitable for causing the circuit to be operated according to the invention with very low values of the current I1.

The transistor T6 has the base connected to the generator of the current I1, the collector connected to the power supply Vb, the emitter connected to the base of the transistor T7. The transistor T7 has the collector connected to the power supply Vb, the emitter connected to the base of the transistor T4.

To the base of the transistor T7 there is also connected the base of the transistor T8. The collector of the transistor T8 is connected to the base of the transistor T6 and the emitter of the transistor T8 is connected to the collector of the transistor T5.

The operation of the circuit of Fig. 2 is altogether similar to that of the circuit of Fig. 1, with the advantage that almost all the current 11 flows through T8, T5, while keeping the base-emitter voltages unchanged as I2 changes.

Applying Kirschhoff's equation to the mesh consisting of R1, T5, T8, T7, T4, R2 we have:${\text{Ic = (R2/R1)∗I2 + kT/qR1∗ln(I2}}^{\text{2}} {\text{/h}}_{\text{FE}} {\text{I1}}^{\text{2}} \text{)}$ Since$\text{I2 = (AD1∗AD2/A2∗A3)Ib}$ substituting (7) in (6), we have an expression of Ic as a function of Ib of the type of that obtained for the circuit of Fig. 1.

The curves of the base current Ib, of the collector current Ic and of the parameter h_{FE} given in Fig.s 3-6 can just as well be applied to the circuit of Fig. 2.

## Claims

1. Driving circuit for a power transistor (T1) comprising a detection resistance (R1) a first circuit part (G1,T4,T5,R2;T4-T8,R2) suitable for generating a first current (I2) depending in a non-linear fashion on a voltage drop across said detection resistance (R1) and a second circuit part (TD2,T3,TD1,T2) suitable for generating a driving base current (Ib) of the power transistor (T1) that is proportional to said first current (I2), characterized in that said power transistor (T1) has a single emitter and said detection resistance (R1) is interposed between said single emitter of the power transistor (T1) and ground, so that a collector current (Ic) of the power transistor entirely flows through the detection resistance (R1), and in that said first circuit part (G1,T4,T5,R2;T4-T8,R2) comprises a current mirror having a gain which is controlled by the voltage developed across said detection resistance (R1) and by a further resistance (R2) inserted between an emitter of an output transistor (T4) of said current mirror and ground, so that the driving base current (Ib) of the power transistor (T1) has a non-linear dependence on the collector current (Ic) of the power transistor (T1) suitable to take into account the gain variation of the power transistor (T1) with its collector current (Ic).

2. Driving circuit according to claim 1, characterised in that said output transistor (T4) has a base operationally connected to the emitter of the power transistor (T1) and to a generator of a constant current (G1).

3. Driving circuit according to claim 2, characterised in that said first circuit part (T4-T8, R2) comprises further transistors (T6, T7, T8) associated with said output transistor (T4) to amplify the value of the base current of said output transistor (T4) in the case where the power transistor is of the high-gain type.

4. Driving circuit according to claim 1, characterised in that said second circuit part (TD2, T3, TD1, T2) comprises two pairs of transistors, each consisting of a transistor (T3, T2) and of a diode-connected transistor (TD2, TD1) arranged in a current-mirror configuration.

5. Driving circuit according to claim 2, characterised in that said further resistance (R2) has a value chosen in a manner such as to vary appropriately the curve of the collector current of said output transistor (T4) and, as a function of it, that of the base current (Ib) of the power transistor (T1) to fit the latter's gain curve.

6. Driving circuit according to claim 5, characterised in that said further resistance (R2) is of the diffuse type and said detection resistance (R1) is constituted by an aluminium track so that the ratio between the collector current (Ic) an the base current (Ib) of the power transistor (T1) with the variation of temperature corresponds to the actual variation in temperature of the gain of said power transistor (T1).

7. Driving circuit according to claim 1, characterised in that said first current (I2) is a collector current of said output transistor (T4) of said current mirror.

## Patentansprüche

1. Treiberschaltung für einen Leistungstransistor (T1), umfassend einen Detektierwiderstand (R1), einen ersten Schaltungsteil (G1, T4, T5, R2; T4-T5, R2) zum Erzeugen eines ersten Stroms (I2), der in nichtlinearer Weise abhängt von einem Spannungsabfall an dem Detektierwiderstand (R1), und einen zweiten Schaltungsteil (TD2, T3, TD1, T2) zum Erzeugen eines Treiber-Basisstroms (Ib) des Leistungstransistors (T1), der proportional zum ersten Strom (I2) ist,
**dadurch gekennzeichnet,**
daß der Leistungstransistor (T1) einen einzelnen Emitter besitzt und der Detektierwiderstand (R1) zwischen dem einzelnen Emitter des Leistungstransistors (T1) und Masse liegt, so daß ein Kollektorstrom (Ic) des Leistungstransistors vollständig durch den Detektierwiderstand (R1) fließt, und daß der erste Schaltungsteil (G1, T4, T5, R2; T4-T8, R2) einen Stromspiegel mit einer Verstärkung aufweist, die gesteuert wird durch die sich an dem Detektierwiderstand (R1) einstellende Spannung sowie durch einen weiteren Widerstand (R2), der zwischen einen Emitter eines Ausgangstransistors (T4) des Stromspiegels und Masse geschaltet ist, so daß der Treiber-Basisstrom (Ib) des Leistungstransistors eine nicht-lineare Abhängigkeit vom Kollektorstrom (Ic) des Leistungstransistors (T1) besitzt, geeignet, um die Verstärkungsschwankung des Leistungstransistors (T1) mit dessen Kollektorstrom (Ic) zu berücksichtigen.

2. Treiberschaltung nach Anspruch 1,
**dadurch gekennzeichnet,**
daß der Ausgangstransistor (T4) eine Basis aufweist, die betrieblich an den Emitter des Leistungstransistors (T1) und an eine Konstantstromquelle (G1) angeschlossen ist.

3. Treiberschaltung nach Anspruch 2,
**dadurch gekennzeichnet,**
daß der erste Schaltungsteil (T4-T8, R2) weitere Transistoren (T6, T7, T8) aufweist, die dem Ausgangstransistor (T4) zugeordnet sind, um den Wert des Basisstroms des Ausgangstransistors (T4) in dem Fall zu verstärken, daß der Leistungstransistor ein Transistortyp hoher Verstärkung ist.

4. Treiberschaltung nach Anspruch 1,
**dadurch gekennzeichnet,**
daß der zweite Schaltungsteil (TD2, T3, TD1, T2) zwei Paare von Transistoren aufweist, jeweils bestehend aus einem Transistor (T3, T2) und einem als Diode geschalteten Transistor (TD2, TD1), die als Stromspiegel geschaltet sind.

5. Treiberschaltung nach Anspruch 2,
**dadurch gekennzeichnet,**
daß der weitere Widerstand (R2) einen Wert aufweist, der so gewählt ist, daß die Kurve des Kollektorstroms des Ausgangstransistors (T4) und als Funktion davon diejenige des Basisstroms (Ib) des Leistungstransistors (T1) so variiert wird, daß eine Anpassung an die Verstärkungskurve des Leistungstransistors erreicht wird.

6. Treiberschaltung nach Anspruch 5,
**dadurch gekennzeichnet,**
daß der weitere Widerstand (R2) ein diffundierter Widerstand ist und der Detektierwiderstand (R1) durch eine Aluminiumbahn gebildet wird, derart, daß das Verhältnis zwischen dem Kollektorstrom (Ic) und dem Basisstrom (Ib) des Leistungstransistors (T1) bei einer Schwankung der Temperatur der augenblicklichen temperaturbedingten Verstärkungsänderung des Leistungstransistors (T1) entspricht.

7. Treiberschaltung nach Anspruch 1,
**dadurch gekennzeichnet,**
daß der erste Strom (I2) ein Kollektorstrom des Ausgangstransistors (T4) des Stromspiegels ist.

## Revendications

1. Circuit de commande d'un transistor de puissance (T1) comprenant une résistance de détection (R1), une première partie de circuit (G1, T4, T5, R2 ; T4-T8, R2) propre à produire un premier courant (I2) qui dépend de façon non-linéaire de la chute de tension aux bornes de la résistance de détection (R1), et une seconde partie de circuit (TD2, T3, TD1, T2) propre à produire un courant de commande de base (Ib) du transistor de puissance (T1) qui est proportionnel au premier courant (I2), caractérisé en ce que le transistor de puissance (T1) a un seul émetteur, en ce que la résistance de détection (R1) est interposée entre l'émetteur unique du transistor de puissance (T1) et la masse, de sorte que tout le courant de collecteur (Ic) du transistor de puissance circule dans la résistance de détection (R1), et en ce que la première partie de circuit (G1, T4, T5, R2 ; T4-T8, R2) comprend un miroir de courant ayant un gain qui est contrôlé par la tension aux bornes de la résistance de détection (R1) et par une autre résistance (R2) insérée entre l'émetteur d'un transistor de sortie (T4) du miroir du courant et la masse, de sorte que le courant de commande de base (Ib) du transistor de puissance (T1) dépend non-linéairement du courant de collecteur (Ic) du transistor de puissance (T1) de façon appropriée pour tenir compte de la variation de gain du transistor de puissance (T1) par son courant de collecteur (Ic).

2. Circuit de commande selon la revendication 1, caractérisé en ce que le transistor de sortie (T4) a une base opérationnellement connectée à l'émetteur du transistor de puissance (T1) et à un générateur de courant constant (G1).

3. Circuit de commande selon la revendication 2, caractérisé en ce que la première partie de circuit (T4-T8, R2) comprend en outre des transistors (T6, T7, T8) associés au transistor de sortie (T4) pour amplifier la valeur du courant de base du transistor de sortie (T4) dans le cas où le transistor de puissance est du type à gain élevé.

4. Circuit de commande selon la revendication 1, caractérisé en ce que la seconde partie de circuit (TD2, T3, TD1, T2) comprend deux paires de transistors comprenant chacun un transistor (T3, T2) et un transistor connecté en diode (TD2, TD1) disposé en configuration de miroir de courant.

5. Circuit de commande selon la revendication 2, caractérisé en ce que l'autre résistance (R2) a une valeur choisie de façon à faire varier de façon appropriée la courbe du courant de collecteur du transistor de sortie (T4), et, en fonction de celui-ci, le courant de base (Ib) du transistor de puissance (T1) pour s'adapter à la dernière courbe de gain.

6. Circuit de commande selon la revendication 5, caractérisé en ce que l'autre résistance (R2) est du type diffusé et en ce que la résistance de détection (R1) est constituée d'une piste d'aluminium, de sorte que le rapport entre le courant de collecteur (Ic) et le courant de base (Ib) du transistor de puissance (T1) en fonction de la variation de la température correspond à la variation réelle en température du gain du transistor de puissance (T1).

7. Circuit de commande selon la revendication 1, caractérisé en ce que le premier courant (I2) est le courant de collecteur du transistor de sortie (T4) du miroir de courant.
